(19) Europäisches Patentamt

European Patent Office

Office européen des brevets

(11) EP 0 536 094 B1

(12) EUROPEAN PATENT SPECIFICATION

(45) Date of publication and mention
of the grant of the patent:
11.12.1996 Bulletin 1996/50

(51) Int Cl.⁶: H03K 17/693

(21) Application number: 92830522.6

(22) Date of filing: 24.09.1992

(54) **Null consumption, nonvolatile programmable switch**

Nichtflüchtiger programmierbarer Schalter mit Null-Leistung

Commutateur programmable non-volatile à consommation nulle

(84) Designated Contracting States:
DE FR GB

(30) Priority: 26.09.1991 IT VA910035

(43) Date of publication of application:
07.04.1993 Bulletin 1993/14

(73) Proprietor: SGS-THOMSON
MICROELECTRONICS S.r.l.
20041 Agrate Brianza (Milano) (IT)

(72) Inventors:
• Daniele, Vincenzo
I-20047 Brugherio (IT)
• Benedetti, Mirella
I-20059 Vimercate (IT)

(74) Representative: Pellegri, Alberto et al
c/o Società Italiana Brevetti S.p.A.
Via Puccini, 7
21100 Varese (IT)

(56) References cited:
EP-A- 0 204 300          US-A- 5 016 217

## Description

The most widely diffused families of integrated logic devices (74HC... FAST, ACL, ... etc.) offer altogether a wide range of products, many of which differ among each other only in respect to some specific functions, such as for example output/ouput, enable/enable, CMOS/TTL input levels, tristate/no-tristate, input pull-up/no pull-up, and the like. Commercially available devices are divided, in terms of compatibility among each other, into "families" (as the above noted ones) which could be replaced by a more limited number of standard devices if, after having implemented on the same chip several different circuit configurations, an end user could select by programming a certain desired configuration from the many available.

So far such an approach has been considered unapplicable because it would require a certain number of additional pins for driving a selection circuitry and therefore a pin configuration different from the standard configuration commonly used in these integrated circuits.

The document US-A-5,016,217 describes an EPROM memory cell array wherein each cell may be tri-statable by the use of a floating-gate type CMOS transistor pair associated to each cell. The current terminals of the floating gate CMOS pair may be connected to the supply rails, respectively, or in the alternative the source of the p-channel transistor of the pair may be interconnected with the common control gates of the cell. A control signal is applied to the control gates of the CMOS pair for eventually setting the cell in a tristate mode.

A different type of problem is encountered in so-called PLD (Programmable Logic Devices) wherein the logic circuitry is configured by selecting the inputs to be connected to the AND and/or OR levels or the electrical paths within an output macrocell. In these devices, the control signals are generated by relatively sophisticated level-regeneration systems or by sense-amplifiers capable of discriminating the state of programmable memory cells of a RAM, EPROM, EEPROM, FLASH type and alike.

In both these different contexts, there is a need for a circuit structure which, in the first of said contexts will permit a selection between a number of possible different configurations of the integrated circuit without the need for dedicated selection pins and, in the second context, to generate in a simpler manner the configuring control signals, without increasing power dissipation.

This twofold objective is attained by the present invention by use of an integrated CMOS switch capable of acting as a selector of either a logic signal path in one type fo application or a certain function in a second type of application and which basically utilizes as a control element a floating gate which is substantially shared with an electrically programmable and erasable, nonvolatile memory cell, i.e. a FLASH-EPROM or an EEPROM cell or alike.

As a consequence, the state of the CMOS switch depends directly from the relative charge stored in the floating gate of the memory cell which is associated to the CMOS switch. The state of charge is easily alterable by the user of the integrated circuit simply by writing/erasing the memory cell and this state is retained also when the circuit is not powered. The device of the invention does not require any alteration of the pin configuration of the integrated device because the programming phase for configuring the integtrated circuit precedes the operating phase of the configured integrated circuit and therefore it is possible to exploit the standardized pin configuration of the integrated circuit also for pre-configuring the functional circuit.

As an alternative, by adding external pin connections, it is possible to manage the programming of the configuration of the device by means of an application software capable of modifying, in real time and directly on card, functional/electrical characteristics of the integrated circuit, thus adapting them to the performance requirements of an user's program.

The different aspects and advantages of the invention will become evident through the following description of several embodiments and reference to the annexed drawings, wherein:

**Figure 1** is an electrical diagram of a CMOS switch of the present invention;

**Figure 2** is an electrical diagram of a path selector, realized by means of an integrated CMOS switch of the invention;

**Figure 3** is an electrical diagram of a polarity selector, realilzed by means of an integrated CMOS switch of the invention;

**Figure 4** shows a functional diagram of a tristate/notristate output type selector, realized by means of a CMOS switch of the invention;

**Figure 5** shows a functional diagram of an Iout selector for a buffer of an integrated logic circuit;

**Figure 6** shows the electrical diagram of a cell of the current selector of FIg. 4, implemented by means of an integrated CMOS switch of the invention;

**Figure 7** shows an electrical diagram of a cell of the current selector of Fig. 4, implemented by means of an integrated CMOS switch made according to an alternative embodiment of the invention;

**Figure 8** is a functional diagram of a polarity selector for an integrated CMOS circuit made in accordance with the prior art;

**Figure 9** is a functional diagram of a polarity selector for a PLD circuit utilizing a programmable control device, in accordance with the prior art.

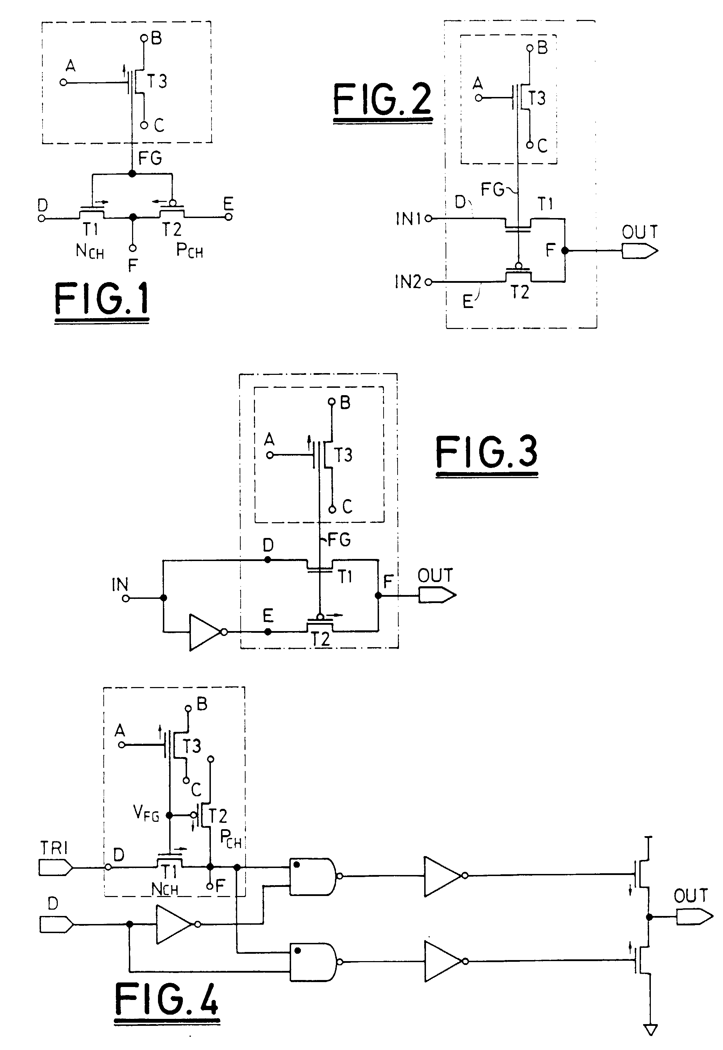

With reference to Fig. 1, the structure of an integrated CMOS switch made in accordance with the present invention is composed of a pair of complementary transistors T1 and T2 sharing a common drain (F) and a common gate (FG). This common gate FG, in turn, is essentially connected to the floating gate of a FLASH-EPROM or an EEPROM type memory cell T3, which is evidenced in the figure by a dash-line perimeter surrounding it. Preferably in the integrated structure, the two transistors and the memory cell share a physically unitary floating gate structure. The source of the n-channel transistor T1 may be functionally connected to a first node D, e.g. to a Vdd supply rail, while the source of the p-channel transistor T2 may be connected to a node E having a different potential, e.g. to a Vss rail, (e.g. to ground potential).

The memory cell T3 may be a FLASH type cell wherein programming takes place through injection of hot electrons from the channel region to the floating gate by applying a relatively high voltage (about 10 V) on the control gate terminal (A) and on the drain terminal (B) while the source terminal (C) is kept to ground potential (e.g. similarly to what happens in a UV-EPROM), while erasing of the programmed cell is achieved by transfer of electrons, through a mechanism known as the Fowler-Nordheim mechanism from the floating gate FG to the source (C), through a tunnel oxide. Conversely, in the case the memory cell T3 is an EEPROM type cell, both writing (programming) and erasing operations take place by tunnelling of electrical charge to and from the floating gate through a dedicated tunnel oxide area.

It should be noted that the voltage level which may be attained by the floating gate FG may reach relatively high positive values (even higher than the supply voltage Vcc of the integrated circuit) and negative values (below ground potential).

In a first state, e.g. with the floating gate at a voltage level corresponding to a logic "1" ($V_{FG}$ = "1"), only the n-channel transistor T1 is conducting (ON) and therefore the output node F takes the potential of the D node. In a second state, e.g. when $V_{FG}$ = "0", the p-channel transistor T2 is conducting (ON), while the n-channel transistor T1 is switched-off (OFF) and therefore the potential of the E node becomes available on the output node F.

It is evident that this integrated structure has the following characteristics.

1) A null power consumption under static conditions due to the use of complementary (p-channel and n-channel) transistors, which cannot be conducting simultaneously.

2) Ability to drive the transistors T1 and T2 with a (floating) gate voltage more positive than the maximum supply voltage (e.g. > Vcc) and more negative than ground potential (e.g. < Vss). This permits to transfer to the output node F integer voltage values which are present on the D and E nodes, respectively, and therefore attain a null static consumption also through the logic gates which are eventually driven through the output node F of the circuit. Moreover this permits to lower the ON-resistance of the transistors T1 and T2, thus making this switching structure particularly suited for fast circuits.

3) Direct exploitation of the potential of the floating gate of the FLAHS or EEPROM memory cell <u>as a logic control signal</u> of the switch formed by the pair of complementary transistors T1 and T2, eliminates the necessity of placing an "interfacing" circuit between the memory element T3 and the controlled circuit, capable of acting as a "sensor" of the state of the memory element T3 and as a logic level regenerating stage, e.g. a sense amplifier.

4) The integrated structure behaves as a switch capable of selecting between a supply voltage and ground or between two different logic levels in a programmable and nonvolatile manner.

A path selector, made according to the present invention by utilizing an integrated CMOS switch similar to the one described in Fig. 1, is depicted in Fig. 2, wherein the above-described integrated switch's structure of Fig. 1, is evidenced by an encompassing perimeter, drawn with a dash-point line.

The operation of the path selector depicted is easily understood. If the floating gate FG has a negative charge, the state of the output node OUT is equal to the state of the input node IN2: ($V_{FG}$ = "0" OUT = IN2). If the floating gate FG is positively charged, the state of the output is identical to the state of the input: ($V_{FG}$ = "1" OUT = IN1).

A polarity selector made according to the present invention by utilizing an integrated CMOS switch similar to the one shown in Fig. 1, is depicted in Fig. 3, wherein the structure of the integrated switch is evidenced by a perimeter drawn with a dash-point line.

The operation of the polarity selector depicted is of immediate comprehension. If the floating gate FG is negatively charged, the state of the output is inverted as compared to the state of the input: ($V_{FG}$ = "0" OUT = $\overline{IN}$). If the floating gate FG is positively charged, the state of the output is equal to the state of the input: ($V_{FG}$ = "1" OUT = IN).

An output type selector (e.g. tristate/notristate), made in accordance with the present invention by utilizing a switch as the one described in relation to Fig. 1, is shown in Fig. 4. Also in this case the switch's structure of the invention is put in evidence by a perimeter drawn with a dash-point line.

Notably, the circuit shown in Fig. 4 is used for activating or disactivating in a programmable manner a TRI signal which permits to enable a so-called "tristate" mode of operation of an output buffer of an integrated logic circuit.

Also in this case the operation of the circuit is of immediate comprehension.

When the floating gate FG is negatively charged, the transistor T1 is OFF and therefore the TRI signal is blocked, viceversa, when the floating gate FG is positively charged, the transistor T1 conducts and therefore the TRI signal is enabled:

$$V_{FG} = \text{"0" notristate buffer}$$

$$V_{FG} = \text{"1" tristate buffer}$$

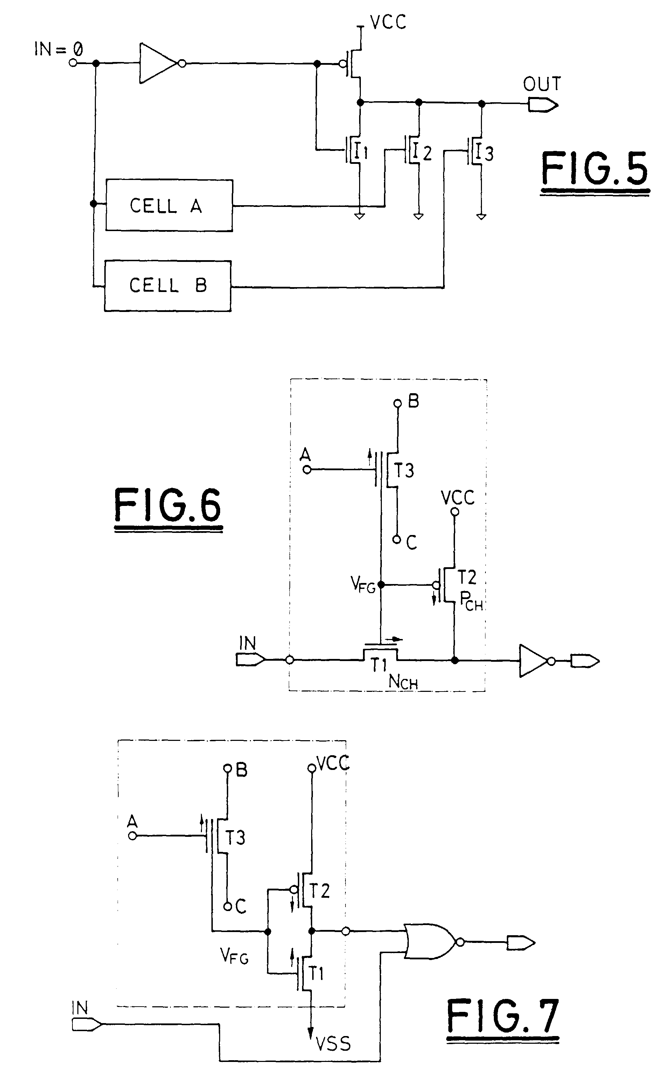

An output current (Iout) selector for an output buffer of an integrated logic circuit is schematically depicted in Fig. 5. The paths selection cells A and B utilized in the current selector circuit of Fig. 5 may conveniently be made in accordance with the present invention by utilizing a programmable integrated CMOS switch structure similar to the structure described in relation to Fig. 1.

According to a first embodiment, each of the cells A and B of the current selector circuit of Fig. 5 may be realized by utilizing a nonvolatile programmable switching structure of the invention, as depicted in Fig. 6, wherein the structure of the CMOS switch of Fig. 1 is evidenced by means of a perimeter drawn with a dash-point line. According to this first embodiment, on the input node of an inverter of each cell, either an input signal IN or the supply voltage Vcc is transferred.

According to an alternative embodiment, each cell (A and B) of the current selector circuit of Fig. 5 may have a functional diagram as the one depicted in Fig. 7.

According to this alternative embodiment, to an input node of a NOR circuit a signal may be transferred whose level may vary between a ground potential Vss and a supply voltage Vcc, and which will act, in a logical manner, as an enabling signal for the transfer of a signal IN which is fed to another input node of the NOR circuit.

Of course the two solutions of Figures 6 and 7, though different, are logically equivalent to each other.

When the input signal IN = "0", if the floating gates of the switching structure of the current selector's cells A and B are both negatively charged, the output current Iout will be equal to I1 (Iout = I1);

if the floating gate of the A cell is positively charged and the floating gate of the B cell is negatively charged, then: Iout = I1 + I2;
if the floating gate of the A cell is negatively charged and the floating gate of the B cell is positively charged, then: Lout = I1 + I3;
if the floating gates of the A and B cells are both positively charged, the output current will be given by: Iout = I1 + I2 + I3.

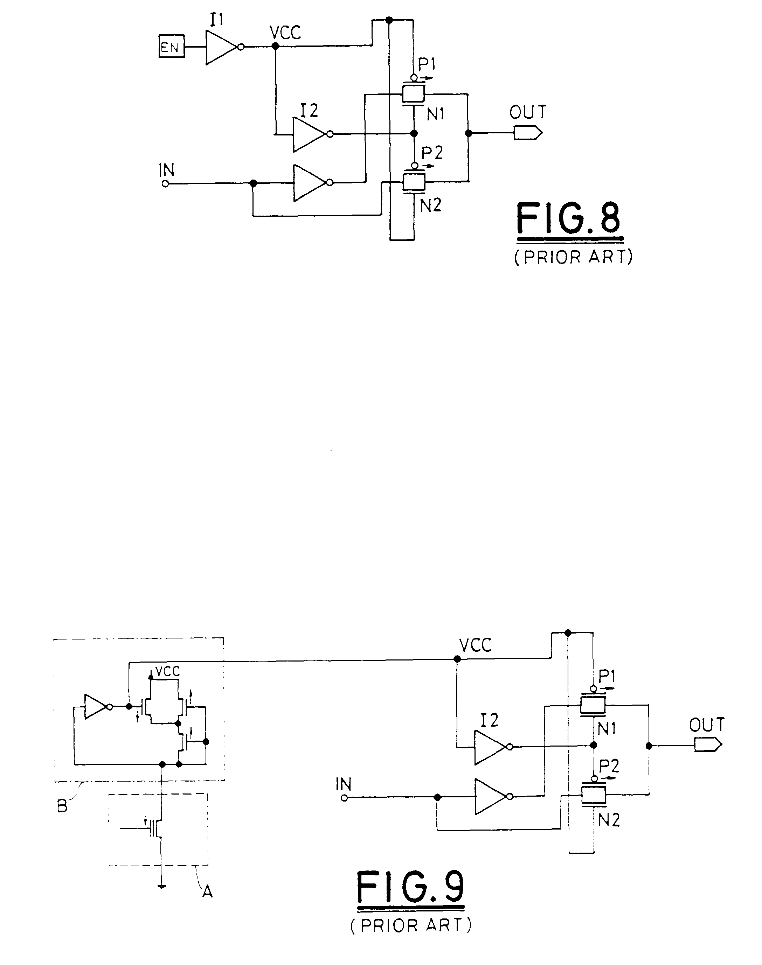

A functional block diagram of another known type of polarity selector is depicted in Fig. 8. Commonly, in a case like this, it would be necessary to logically drive the $V_{CC}$ signal and therefore to use an additional EN pin and implement the relative driving logic circuitry (e.g. the inverters I1 and I2). Complementary pairs: N1, P1 and N2, P2 are normally used as switches for transferring to the output terminal OUT a full voltage level corresponding to the signal present on the input terminal IN. If the $V_{CC}$ = "0", the transistors T1 and N1 are conducting while the transistors P2 and N2 are off and therefore: OUT = $\overline{IN}$. Viceversa, if $V_{CC}$ = "1", P1 and N1 are off while P2 and N2 are conducting and transfer to the output the input signal: OUT = IN.

As depicted in Fig. 9, in so-called PLD devices, additional driving pins are not necessary actually because the driving is implemented by utilizing a control signal made available by a sense amplifier which reads the state of a certain programmable memory cell. The relative circuit diagram is depicted in Fig. 9, wherein the A perimeter identifies a generic memory cell and the B perimeter identifies a sense amplifier for discriminating the stage of the addressed memory cell, in accordance to a known configuration.

Also in this type of applications, the same function, which in accordance to the prior art is performed by the A cell and by the sense amplifier circuit B, may be more conveniently performed by an integrated CMOS switch made in accordance with the present invention, by utilizing a circuit as the one depicted in Fig. 3.

**Claims**

1. A null consumption integrated switch comprising a pair of complementary transistors (TI, T2) each having a drain, a source and a single gate, a source of a transistor (T1) of said pair being functionally connected to a first voltage node (D) and a source of the other transistor (T2) of said pair being functionally connected to a second voltage node (E) of the integrated circuit, the drains of the two transistors being connected in common; the gates of the two transistors being connected in common; characterized in that

   a programmable and erasable memory cell (T3) has a chargeable and dischargeable floating gate (FG) directly connected to said single gates connected in common of said transistors; the state of charge of said floating gate (FG), imposed by programming or erasing said memory cell, determining the connection of the first or the second voltage node to an output node (F) of the switch which coincides with the common drain of said transistors.

2. An integrated switch as defined in claim 1, wherein said programmable and erasable memory cell (T3) is a FLASH-EPROM cell.

3. An integrated switch as defined in claim 1, wherein said programmable and erasable memory cell (T3) is an EEPROM cell.

4. An integrated switch as defined in claim 1, wherein said complementary pair of transistor (T1, T2) share a unitary drain region and share a unitary floating gate structure (FG) with said programmable and erasable cell (T3).

5. A null consumption switch as defined in any of the preceding claims, configured as an integrated path selector comprising a circuit emboding two electrical paths, each provided with an interruption means between an input terminal (IN1, IN2) and an output terminal (OUT), wherein each of said interruption means is formed by one of said complementary pair of transistors (T1, T2) having a common drain (F) connected to one of said terminals of the circuit and having a gate which is connected to the floating gate (FG) of said programmable and erasable memory cell (T3).

6. A path selector according to claim 5, wherein said common drain (F) of said complementary pair of transistors (T1, T2) is connected to the output terminal (OUT) of the circuit, the source of a first transistor (T1) of said pair is connected to a first input terminal (IN1) of the circuit and the source of the other transistor (T2) of said pair is connected to a second input terminal (IN2) of the circuit.

7. A null consumption switch as defined in any of the claims 1 to 4, configured as an integrated polarity selector comprising a circuit implementing two electrical paths each provided with an interruption means between an input (IN) and an output terminal (OUT) thereof and wherein one of said electrical paths comprises an inverter, said interruption means being said complementary pair of transistors (T1, T2) having a common drain (F) connected to one of said terminals of the circuit (OUT) and a gate which is connected to a floating gate (FG) of said integrated programmable and erasable memory cell (T3).

8. A polarity selector according to claim 7, wherein said common drain (F) of said complementary pair of transistors (T1, T2) is connected to the output terminal (OUT) of the circuit, a source of a first transistor of said pair is connected to the input terminal (IN) of the circuit and a source of the other transistor (T2) of said pair is connected to the output (E) of said inverter.

**Patentansprüche**

1. Integrierter Schalter mit Null-Leistungsverbrauch, mit einem Paar von komplementären Transistoren (T1, T2), die jeweils einen Drain-Anschluß, einen Source-Anschluß und einen einzelnen Gate-Anschluß besitzen, wobei ein Source-Anschluß eines Transistors (T1) des Paars funktionell mit einem ersten Spannungsknoten (D) verbunden ist und ein Source-Anschluß des anderen Transistors (T2) des Paars funktionell mit einen zweiten spannungsknoten (E) der integrierten Schaltung verbunden ist, die Drain-Anschlüsse der zwei Transistoren miteinander verbunden sind und die Gate-Anschlüsse der zwei Transistoren miteinander verbunden sind; dadurch gekennzeichnet, daß

eine programmierbare und löschbare Speicherzelle (T3) ein aufladbares und entladbares schwebendes Gate (FG) besitzt, das direkt mit den einzelnen, miteinander verbundenen Gate-Anschlüssen der Transistoren verbunden ist;

der Zustand der Ladung des schwebenden Gates (FG), der durch Programmieren oder Löschen der Speicherzelle hervorgerufen wird, den Anschluß des ersten oder des zweiten Spannungsknotens mit einem Ausgangsknoten (F) des Schalters bestimmt, der mit dem gemeinsamen Drain-Anschluß der Transistoren übereinstimmt.

2. Integrierter Schalter nach Anspruch 1, bei dem die programmierbare und löschbare Speicherzelle (T3) eine FLASH-EPROM-Zelle ist.

3. Integrierter Schalter nach Anspruch 1, bei dem die programmierbare und löschbare Speicherzelle (T3) eine EEPROM-Zelle ist.

4. Integrierter Schalter nach Anspruch 1, bei dem das komplementäre Paar von Transistoren (T1, T2) einen einzelnen Drain-Bereich und eine einzige schwebende Gate-Struktur (FG) gemeinsam mit einer programmierbaren und löschbaren Zelle (T3) benutzt.

5. Schalter mit Null-Leistungsverbrauch nach irgendeinem der vorangehenden Ansprüche, der als integrierte Pfadauswahlvorrichtung konfiguriert ist, die eine Schaltung umfaßt, die zwei elektrische Pfade enthält, die jeweils mit einer Unterbrechungsvorrichtung zwischen einem Eingangsanschluß (IN1, IN2) und einem Ausgangsanschluß (OUT) versehen sind, wobei jede der Unterbrechungsvorrichtungen durch eines der komplementären Transistorpaare (T1, T2) gebildet ist, die einen gemeinsamen Drain-Anschluß (F), der mit einem der Anschlüsse der Schaltung verbunden ist, und einen Gate-Anschluß besitzen, der mit dem schwebenden Gate (FG) der programmierbaren und löschbaren Speicherzelle (T3) verbunden ist.

**6.** Pfadauswahlvorrichtung nach Anspruch 5, in der der gemeinsame Drain-Anschluß (F) des komplementären Transistorpaars (T1, T2) mit dem Ausgangsanschluß (OUT) der Schaltung verbunden ist, wobei der Source-Anschluß eines ersten Transistors (T1) des Paars mit einem ersten Eingangsanschluß (IN1) der Schaltung verbunden ist und der Source-Anschluß des anderen Transistors (T2) des Paars mit einem zweiten Eingangsanschluß (IN2) der Schaltung verbunden ist.

**7.** Schalter mit Null-Leistungsverbrauch nach irgendeinem der Ansprüche 1 bis 4, der als integrierte Polaritätsauswahlvorrichtung konfiguriert ist, die eine Schaltung umfaßt, die zwei elektrische Pfade enthält, die jeweils mit einer Unterbrechungsvorrichtung zwischen einem Eingangsanschluß (IN) und einem Ausgangsanschluß (OUT) versehen sind, wobei einer der elektrischen Pfade einen Invertierer enthält und wobei die Unterbrechungsvorrichtung ein komplementäres Transistorpaar (T1, T2) mit einem gemeinsamen Drain-Anschluß (F), der mit einer der Anschlüsse der Schaltung (OUT) verbunden ist, sowie einem Gate-Anschluß ist, der mit einem schwebenden Gate (FG) der integrierten programmierbaren und löschbaren Speicherzelle (T3) verbunden ist.

**8.** Polaritätsauswahlvorrichtung nach Anspruch 7, bei der der gemeinsame Drain-Anschluß (F) des komplementären Transistorpaars (T1, T2) mit dem Ausgangsanschluß (OUT) der Schaltung verbunden ist, ein Source-Anschluß des ersten Transistors (T1) des Paars mit dem Eingangsanschluß (IN) der Schaltung verbunden ist und ein Source-Anschluß des anderen Transistors (T2) des Paars mit dem Ausgangsanschluß (E) des Invertierers verbunden ist.

**Revendications**

**1.** Commutateur intégré à consommation nulle comprenant une paire de transistors complémentaires (T1, T2) ayant chacun un drain, une source et une grille unique, la source d'un transistor (TI) de la paire étant fonctionnellement connectée à un premier noeud de tension (D) et la source de l'autre transistor (T2) de la paire étant fonctionnellement connectée à un second noeud de tension (E) du circuit intégré, les drains des deux transistors étant interconnectés, les grilles des deux transistors étant interconnectées ; caractérisé en ce que :

une cellule mémoire programmable et effaçable (T3) comporte une grille flottante chargeable et déchargeable (FG), directement connectée aux grilles uniques interconnectées des transistors ;
l'état de charge de la grille flottante (FG), imposé par la programmation ou l'effacement de la cellule mémoire déterminant la connexion du premier ou du second noeud de tension à un noeud de sortie (F) du commutateur qui coïncide avec le drain commun des transistors.

**2.** Commutateur intégré selon la revendication 1, dans lequel la cellule mémoire programmable et effaçable (T3) est une cellule FLASH-EPROM.

**3.** Commutateur intégré selon la revendication 1, dans lequel la cellule mémoire programmable et effaçable (T3) est une cellule EEPROM.

**4.** Commutateur intégré selon la revendication 1, dans lequel les deux transistors complémentaires (T1, T2) partagent une même région de drain et partagent une structure de grille flottante unique (FG) avec la cellule programmable et effaçable (T3).

**5.** Commutateur à consommation nulle selon l'une quelconque des revendications précédentes connecté en tant que sélecteur de trajet intégré, comprenant un circuit mettant en oeuvre deux trajets électriques, chacun muni d'un moyen d'interruption entre une borne d'entrée (IN1, IN2) et une borne de sortie (OUT), dans lequel chacun des moyens d'interruption est constitué de l'un des deux transistors complémentaires (T1, T2) ayant un drain commun (F) connecté à l'une des bornes du circuit et ayant une grille connectée à la grille flottante (FG) de la cellule mémoire programmable et effaçable (T3).

**6.** Sélecteur de trajet selon la revendication 5, dans lequel le drain commun (F) de la paire de transistors complémentaires (T1, T2) est connecté à la borne de sortie (OUT) du circuit, la source d'un premier transistor (T1) de la paire est connectée à une première borne d'entrée (IN1) du circuit, et la source de l'autre transistor (T2) de la paire est connectée à une seconde borne d'entrée (IN2) du circuit.

**7.** Commutateur à consommation nulle selon l'une quelconque des revendications 1 à 4, connecté en sélecteur de polarité intégré comprenant un circuit mettant en oeuvre deux trajets électriques comportant chacun un moyen d'interrupteur entre une entrée (IN) et une sortie (OUT) de ce trajet et dans lequel l'un des trajets électriques comprend un inverseur, le moyen d'interruption étant ladite paire de transistors complémentaires (T1, T2) ayant un drain commun (F) connecté à l'une des bornes du circuit (OUT) et dont une grille est connectée à une grille flottante (FG) de la cellule mémoire intégrée programmable et effaçable (T3).

8. Sélecteur de polarité selon la revendication 7, dans lequel le drain commun (F) de la paire de transistors complémentaires (T1, T2) est connecté à la borne de sortie (OUT) du circuit, la source d'un premier transistor de la paire est connectée à la borne d'entrée (IN) du circuit, et la source de l'autre transistor (T2) de la paire est connectée à la sortie (E) de l'inverseur.

FIG.1

FIG.2

FIG.3

FIG.4

## FIG.5

## FIG.6

## FIG.7

# FIG.8
(PRIOR ART)

# FIG.9
(PRIOR ART)